# EUROPÄISCHE PATENTSCHRIFT

(11) **EP 1 130 756 B1**
(45) Veröffentlichungstag und Bekanntmachung des Hinweises auf die Patenterteilung: **07.06.2006**
(21) Anmeldenummer: 01200747.2
(22) Anmeldetag: 28.02.2001
(51) Int. Cl.: H02N 2/10, H01L 41/09, B26B 19/28

(54) **Piezoelektischer Aktuator**
Piezoelectric actuator
Actionneur piézoélectrique

(30) Priorität: 04.03.2000 DE 10010707
(43) Veröffentlichungstag der Anmeldung: 05.09.2001
(73) Patentinhaber: Philips Intellectual Property & Standards GmbH, 20099 Hamburg (DE); Koninklijke Philips Electronics N.V., 5621 BA Eindhoven (NL)
(72) Erfinder: Diefenbach, Gerhard, 52064 Aachen (DE); Reichinger, Christian, Dr., 52064 Aachen (DE)
(74) Vertreter: Volmer, Georg

(56) Entgegenhaltungen:
- DE-A1- 19 817 038
- US-A- 4 019 073
- US-A- 5 877 579
- FLEISCHER M ET AL: "NOVEL ULTRASONIC MOTORS WITH MONO- AND BIMODAL DRIVES" SENSORS AND ACTUATORS A, ELSEVIER SEQUOIA S.A., LAUSANNE, CH, Bd. A21, Nr. 1 / 3, 1. Februar 1990 (1990-02-01), Seiten 357-361, XP000149595 ISSN: 0924-4247

## Beschreibung

Die Erfindung betrifft einen piezoelektrischen Aktuator zum Antrieb eines beweglichen Teils mit einem länglichen piezoelektrischen Resonator, welcher dazu vorgesehen ist, Longitudinalschwingungen auszuführen, und auf welchen elastische Mittel einwirken.

Der Einsatz piezoelektrischer Antriebe in kleinen Elektrogeräten gewinnt immer mehr an Bedeutung, da diese Antriebsform sehr robust, kompakt und flexibel einsetzbar ist. Ein solcher piezoelektrischer Antrieb ist in der Schrift US 4,019,073 dargestellt. Es handelt sich dabei um einen longitudinalschwingenden piezoelektrischen Resonator, der eine Welle antreibt. Weiterhin ist das der Welle zugewandte Ende des piezoelektrischen Resonators an einer Feder befestigt, wobei die Feder eine Kraft senkrecht auf den Rotor ausübt und diesen gegen die Welle gedrückt. Durch diese wird der Wirkungsgrad nachteilig beeinflusst.

Es ist die Aufgabe der vorliegenden Erfindung, einen piezoelektrischen Aktuator mit hohem Wirkungsgrad zu schaffen.

Die Aufgabe wird erfindungsgemäß dadurch gelöst, dass mindestens ein piezoelektrischer Resonator und ein Federmittel, welches eine Kraft auf den piezoelektrischen Resonator zumindest in Richtung seiner Longitudinalschwingungen ausübt, so angeordnet sind, dass sich das Federmittel auf den piezoelektrischen Resonator abstützt, wobei die Resonanzfrequenz des Federmittels viel kleiner als die Resonanzfrequenz des piezoelektrischen Resonators ist.

Diese Lösung bietet den großen Vorteil, dass der piezoelektrische Resonator in longitudinaler Schwingungsrichtung ohne große Widerstände zu überwinden schwingen kann, wenn sich der Resonator ausdehnt, übt er eine Kraft auf das bewegliche Teil aus, wodurch das bewegliche Teil in Bewegung versetzt wird. Diese Kraft kann nur ausgeübt werden, wenn sie eine Gegenkraft erfährt. Diese Gegenkraft bringt das elastische Mittel auf. Wenn sich der Resonator zusammenzieht, muss die Gegenkraft des elastischen Mittels so gering wie möglich sein. Dies ist dadurch möglich, dass piezoelektrischer Resonator und elastisches Mittel nicht aneinander befestigt sind, sondern sich nur aufeinander abstützen und durch die unterschiedlichen Resonanzfrequenzen von piezoelektrischem Resonator und Federmittel auch den Kontakt zueinander verlieren können. Je ungehinderter ein piezoelektrischer Resonator schwingen kann, desto höher fällt sein Wirkungsgrad aus. Im Gegensatz dazu muss der piezoelektrische Resonator nach US 4,019,073 einen Teil der zugeführten elektrischen Energie dazu aufwenden, Reibungswiderstände zu überwinden und das Federmittel zu spannen.

In der Ausgestaltung nach Anspruch 2 treibt der piezoelektrische Resonator einen Rotor an. Um den Wirkungsgrad weiter zu steigern, ist es wichtig, den optimalen Winkel zwischen piezoelektrischem Resonator und dem Rotor zu finden. Dieser Winkel ist unter anderem abhängig von der Materialbeschaffenheit von Resonator und Rotor und dem davon abhängigen Reibungskoeffizienten. Mittels dieses Koeffizienten lässt sich der optimale Winkel berechnen und einstellen.

Die Ausgestaltung nach Anspruch 3 bietet den Vorteil, dass der piezoelektrische Resonator an seinem dem Rotor zugewandten Ende dem Rotor nicht ausweichen kann. So wird ein Wegdrehen des Resonators vom Rotor zuverlässig verhindert.

In der Ausgestaltung nach Anspruch 4 wird das Problem berücksichtigt, dass sich durch die Reibung zwischen piezoelektrischem Resonator und den Führungselementen und die Andruckkraft des Resonators auf den Rotor der Winkel mit der Zeit vergrößert, da durch Abnutzungserscheinungen ein Materialabtrag stattfindet. Um diesem vorzubeugen, wird der Winkel ein wenig kleiner gewählt als berechnet, womit der im Betrieb erfolgenden Winkelvergrößerung Rechnung getragen ist.

Die Ausgestaltung nach Anspruch 5 verbessert die Kraftübertragung des piezoelektrischen Resonators. Damit der Wirkungsgrad erhöht wird, ist es von Vorteil, ein hartes Material am dem Rotor zugewandten Ende des piezoelektrischen Resonators aufzubringen. Dieses Material ist abnutzungsbeständig und stellt gleichzeitig den für eine gute Kraftübertragung zwischen Resonator und Rotor notwendigen hohen Reibungskoeffizienten sicher.

Der Mehrschichtresonator nach Anspruch 6 lässt sich mit deutlich geringeren Spannungen betreiben als ein herkömmlicher Einschichtresonator. Dies senkt den Energieverbrauch.

Die Ausgestaltung nach Anspruch 7 sorgt dafür, dass weniger Energie über die Kontaktstellen zwischen Resonator und Führungselementen normal zum Resonator in die Führungselemente übertragen wird. Resonator und Führungselemente sind deshalb bewusst akustisch fehlangepasst.

Nach Anspruch 8 ist vorgesehen, den piezoelektrischen Aktuator in einem elektrisch betriebenen Rasierapparat als Antrieb der Schneidwerkzeuge einzusetzen. Hierdurch wird der Energieverbrauch und das Gewicht im Vergleich zu Rasierapparaten mit herkömmlichen Elektromotoren deutlich gesenkt.

Die Ausgestaltungen nach Anspruch 9 und 10 betreffen einen Rasierapparat mit rotierendem Schneidwerkzeug. Durch den Einsatz der raumsparenden piezoelektrischen Aktuatoren ist es möglich, in einem Rasierapparat mit mehreren Rotoren diese mit je einem Antrieb zu versehen. Dadurch können die Rotoren völlig unabhängig voneinander gesteuert werden und mit unterschiedlichen Drehzahlen laufen. Herkömmliche Elektromotoren benötigen so viel Platz, dass speziell bei Rasierapparaten nur Platz für einen Motor vorhanden ist. Drehzahlunterschiede zwischen den gemeinsam angetriebenen Rotoren lassen sich dann höchstens durch ein Getriebe verwirklichen, was den Bauaufwand erhöht und keine variablen Drehzahlunterschiede zwischen den Rotoren ermöglicht.

Ausführungsbeispiele der Erfindung werden nachfolgend an Hand der Figuren näher erläutert. Es zeigen:
Figur 1 einen piezoelektrischen Aktuator mit einem piezoelektrischen Resonator, Führungselementen, einer Feder sowie einem anzutreibendem Rotor und
Figur 2 eine schematische Draufsicht eines elektrisch betriebenen Rasierapparates mit drei piezoelektrischen Aktuatoren und drei rotierenden Schneidwerkzeugen.

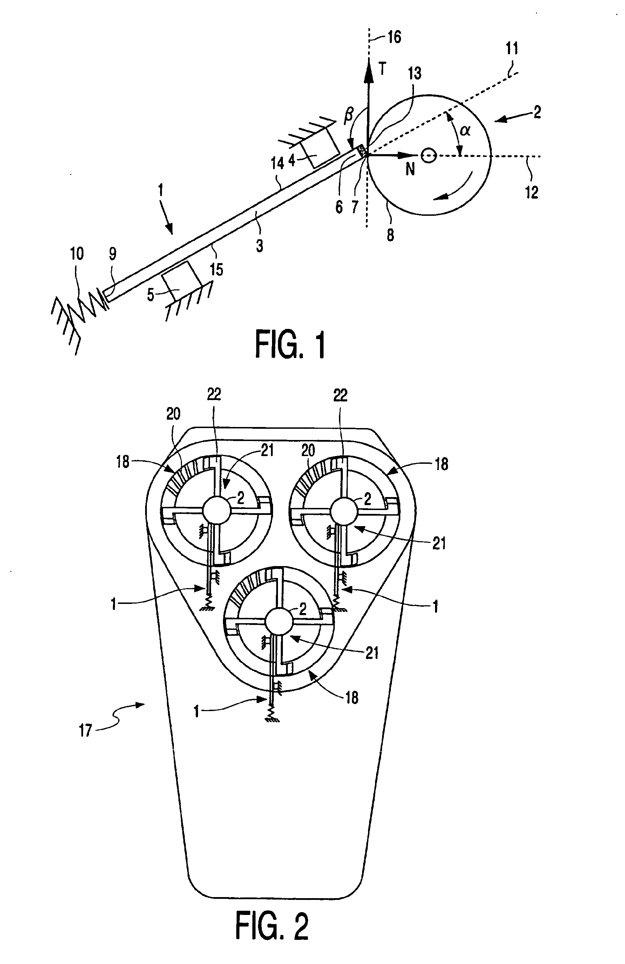

Figur 1 zeigt das Prinzip eines piezoelektrischen Aktuators 1, der einen Rotor 2 antreibt. Der Aktuator hat einen länglichen Resonator 3, der zwischen Führungselementen 4,5 Longitudinalschwingungen ausführen kann. Das eine Ende 6 des Resonators 3 hat einen Berührungspunkt 7 mit der Außenfläche 8 des Rotors 2. Hier findet die Kraftübertragung statt, um der Rotor drehen zu lassen. Am anderer Ende 9 des Resonators stützt sich eine Feder 10 ab, derart dass die Richtung der Kraft der Feder auf den Resonator hauptsächlich gleich der Längsrichtung 11 des Resonators ist. Der Feder stützt sich nur auf den Resonator ab, ohne daran befestigt zu sein. Die Abstützung könnte aber auch an einem anderen Teil des Resonators stattfinden.

Der Resonator 3 bildet mit dem Rotor 2 einen spitzen Winkel α. Der Winkel α ist der Winkel zwischen der Längsrichtung 11 des Resonators 3 und der Normalen 12 auf die Außenfläche 8 des Rotors durch den Berührungspunkt 7. Der für einen optimalen Wirkungsgrad erforderliche Winkel α kann mittels des Reibungskoeffizienten zwischen piezoelektrischem Resonator 3 und Rotor 2 berechnet werden. Hierzu kann verwiesen werden nach EP 01313130. Um Abnutzungserscheinungen zu berücksichtigen, wird der Winkel α jedoch etwas geringer gewählt als der aus dem Reibungskoeffizient zwischen piezoelektrischem Resonator 3 und Rotor 2 berechnete optimale Winkel α. Dieser Reibungskoeffizient kann durch die Wahl einer anderen Materialschicht 13 erhöht werden, welche auf das Ende 6 des piezoelektrischen Resonator 3 aufgebracht wird. Vorzugsweise ist die Materialschicht auch hart, damit sich für den Kontakt eine hohe Kontaktsteifigkeit ergibt. Bei einer hohen Kontaktsteifigkeit wird nur ein geringer Teil der Piezoschwingungsamplitude dazu benötigt, die Normalkraft zu erzeugen. Der Resonator ist länger frei vom Rotor, hat deshalb eine höhere Güte, bei der gleichen angelegten Spannung eine größere , bei dem gleichen abgegebene Drehmoment eine höhere Drehzahl. Dazu erhält der Rotor 2 ebenfalls eine Beschichtung oder besteht ganz aus dem harten Material. Die Materialschicht 13 und die Beschichtung des Rotors sind deshalb so aufeinander abzustimmen, dass die Kontaktsteifigkeit groß ist und gleichzeitig der Reibungskoeffizient zwischen diesen beiden Materialien groß ist. Vorzugsweise handelt es sich bei dem harten Material um Al₂O₃.

Um dem piezoelektrischen Resonator 3 nur Bewegungen in seiner Schwingungsrichtung zu gestatten, wird dieser von zwei sich schräg gegenüberliegenden Führungselementen 4,5 geführt. Diese Führungselemente wirken mit Führungsflächen 14,15 des Resonators 3 zusammen und sind so beschaffen, dass der piezoelektrische Resonator zwischen ihnen ungehindert Longitudinalschwingungen ausführen kann. Dazu bestehen die Führungselemente 4,5 aus einem Material mit einer geringeren akustischen Impedanz als der piezoelektrische Resonator 3. Damit wird weitestgehend verhindert, dass Energie vom Resonator 3 in die Führungselemente 4,5 abgegeben wird. Um bei einem längeren piezoelektrischen Resonator 3 eine bessere Führung zu ermöglichen, können auch mehr als die gezeigten zwei Führungselemente vorhanden sein. In Figur 1 ist außerdem zu sehen, dass die Führungselemente so angeordnet sind, dass sich das mit der Führungsfläche 14 des piezoelektrischen Resonators 3 zusammenwirkende Führungselement 4, wobei die Führungsfläche 14 während des Betriebes vom Rotor 4 ausweichen möchte, näher am Rotor 2 befindet als das andere Führungselement 5. Oder anders gesagt: die Führungsfläche 14 des Resonators 3, die mit dem Führungselement 4 zusammenwirkt, bildet mit der durch den Berührungspunkt 7 verlaufenden Tangentialebene 16 an der Außenfläche 8 des Rotors einen Winkel β größer als 90°.

In der Ruheposition des Resonators 3 liegt die Feder 10 unter einer geringen Vorspannung gegen den Resonator an. Während des Betriebes führt der Resonator Longitudinalschwingungen aus, d.h. er wird abwechselnd länger und kürzer. Während der Periode des Längerwerdens stößt der Berührungspunkt 7 des Resonators gegen die Außenfläche 8 des Rotors 2, was eine Normalkraft N und eine Tangentialkraft T auf den Rotor zur Folge hat. Die Tangentialkraft T bewirkt eine Drehung des Rotors, während die Normalkraft N eine Reaktionskraft auf den Resonator 3 verursacht, die von der Feder 10 und von den Führungselementen 4,5 aufgenommen wird. Während der Periode des Kürzerwerdens löst sich das Ende 9 des Resonators 3 wegen des großen Resonanzfrequenzunterschiedes zwischen der Feder 10 und dem Resonator 3 wenigstens zeitweise von der Feder 10.

In Figur 2 ist ein elektrisch betriebener Rasierapparat 17 mit drei rotierenden Scherköpfen 18 zu sehen. Jeder Scherkopf hat ein Außenschneidelement 19 mit Haareinfangöffnungen 20 und ein Innenschneidelement 21, das gegenüber dem Außenschneidelement 19 antreibbar ist. Das Innenschneidelement 21 hat eine rotierende Welle 2 auf der Meißel 22 angeordnet sind. Diese Welle ist gleichzeitig der in Figur 1 beschriebene Rotor 2, der von dem piezoelektrischen Aktuator 1 angetrieben wird. Jedes Innenschneidelement 21 wird also direkt von einem Aktuator 1 angetrieben. So kann auf ein Getriebe verzichtet werden. Dies ist besonders sinnvoll, wenn die Schneidelemente 20 mit unterschiedlichen Drehzahlen arbeiten sollen. Die Rotoren können völlig unabhängig voneinander gesteuert werden. Es ist auch möglich, jeden Rotor mit mehr als einem Aktuator anzutreiben.

Anstatt einen Rotor anzutreiben, könnte ein erfindungsgemäßer piezoelektrischer Aktuator auch für einen oszillierenden Antrieb eines Gerätes verwendet werden, z.B. zum Antrieb eines Schneidelementes eines sog. Vibrationsrasierapparates. Ein Untersetzungsgetriebe wird dabei eventuell notwendig sein.

## Patentansprüche

1. Piezoelektrischer Aktuator (1) zum Antrieb eines beweglichen Teils (2) mit einem länglichen piezoelektrischen Resonator (3), welcher dazu vorgesehen ist, Longitudinalschwingungen auszuführen, und auf welchen elastische Mittel (10) einwirken,
**dadurch gekennzeichnet,**
**dass** sich das elastische Mittel (10) hauptsächlich in Längsrichtung auf den piezoelektrischen Resonator (3) abstützt und dazu vorgesehen ist, eine Kraft auf den Resonator (3) in Richtung auf das bewegliche Teil (2) auszuüben, wobei die Resonanzfrequenz des elastischen Mittels (10) viel kleiner als die Resonanzfrequenz des piezoelektrischen Resonators (3) ist, und
**dass** der piezoelektrische Resonator (3) senkrecht zu seiner Längsrichtung (11) von wenigstens einem Führungselement (4, 5) geführt wird.

2. Piezoelektrischer Aktuator nach Anspruch 1,
**dadurch gekennzeichnet,**
**dass** der piezoelektrische Resonator (3) einen Rotor (2) antreibt, wobei der piezoelektrische Resonator (3) in Schwingungsrichtung einen spitzen Winkel (α) mit einer Normallinie (12), welche senkrecht zu einer Tangentialebene (16) durch einen Berührungspunkt (7) von Rotor (2) und Resonator (3) verläuft, bildet und dieser Winkel (α) den höchstmöglichen Wirkungsgrad bewirkt.

3. Piezoelektrischer Aktuator nach Anspruch 2,
**dadurch gekennzeichnet,**
**dass** der piezoelektrische Resonator (3) wenigstens zwei gegenüberliegende und mit den Führungselementen (4, 5) zusammenwirkende Führungsflächen (14, 15) aufweist,
wobei sich das Führungselement (4) auf der Führungsfläche (14) des piezoelektrischen Resonators (3), welche mit der Tangentialebene (16) an den Rotor (2) durch den Berührungspunkt (7) von Rotor (2) und Resonator (3) einen Winkel (β) größer als 90° bildet, näher am Rotor (2) befindet als alle weiteren vorhandenen Führungselemente (5), um ein Abheben des piezoelektrischen Resonators (3) vom Rotor (2) zu verhindern.

4. Piezoelektrischer Aktuator nach Anspruch 2,
**dadurch gekennzeichnet,**
**dass** der Winkel (α) kleiner als der für den höchsten Wirkungsgrad optimale Winkel gewählt wird.

5. Piezoelektrischer Aktuator nach Anspruch 2,
**dadurch gekennzeichnet,**
**dass** der piezoelektrische Resonator (1) am Berührungspunkt mit dem Rotor (4) und der Rotor (4) selbst eine Beschichtung aus einem sehr harten Material, insbesondere Al₂O₃, aufweist.

6. Piezoelektrischer Aktuator nach Anspruch 1,
**dadurch gekennzeichnet,**
**dass** der longitudinalschwingende piezoelektrische Resonator (1) ein Mehrschichtresonator ist.

7. Piezoelektrischer Aktuator nach Anspruch 1,
**dadurch gekennzeichnet,**
**dass** das Material der Führungselemente (2a, 2b) eine geringere akustische Impedanz aufweist als das Material des piezoelektrischen Resonators (1).

8. Elektrisch betriebener Rasierapparat mit wenigstens einem Schneidelement (21), dass von wenigstens einem piezoelektrischen Aktuator nach Anspruch 1 angetrieben wird.

9. Elektrisch betriebener Rasierapparat nach Anspruch 8,
**dadurch gekennzeichnet,**
**dass** das Schneidelement (21) einen Rotor (2) aufweist, der rotierend von einem Aktuator (1) nach einem der Ansprüche 2 bis 7 antreibbar ist.

10. Elektrisch betriebener Rasierapparat nach Anspruch 9,
**dadurch gekennzeichnet,**
**dass** dieser mindestens zwei von Rotoren (2) rotierend antreibbare Schneidelemente (21) aufweist und die Rotoren (2) mit unterschiedlichen Drehzahlen rotieren.

## Claims

1. A piezoelectric actuator (1) for driving a movable part (2), having an elongate piezoelectric resonator (3), which serves to perform longitudinal vibrations and which is acted upon by elastic means (10), **characterized in that** the elastic means (10) acts upon the piezoelectric resonator (3) mainly in the longitudinal direction and serves to exert a force on the resonator (3) in a direction towards the movable part (2), the resonant frequency of the elastic means (10) being substantially smaller than the resonant frequency of the piezoelectric resonator (3), and the piezoelectric resonator (3) is guided by at least one guide element (4, 5) in a direction perpendicular to its longitudinal direction (11).

2. A piezoelectric actuator as claimed in claim 1, **characterized in that** the piezoelectric resonator (3) drives a rotor (2), the direction of vibration of the piezoelectric resonator (3) forming an acute angle (α) with respect to a normal (12) which extends perpendicularly to a tangential plane (16) through a point of contact (7) of the rotor (2) and the resonator (3), and this angle (α) provides the maximal efficiency.

3. A piezoelectric actuator as claimed in claim 2, **characterized in that** the piezoelectric resonator (3) has at least two facing guide surfaces (14, 15) which cooperate with the guide elements (4, 5), the guide element (4) which cooperates with the guide surface (14) of the piezoelectric resonator (3), which guide surface forms an angle (β) greater than 90° with respect to the tangential plane (16) to the rotor (2) through the point of contact (7) of the rotor (2) and the resonator (3), being situated closer to the rotor (2) than any other guide element (5), in order to prevent the piezoelectric resonator (3) from being moved off the rotor (2).

4. A piezoelectric actuator as claimed in claim 2, **characterized in that** the angle (α) is selected to be smaller than the optimum angle for which the efficiency is maximal.

5. A piezoelectric actuator as claimed in claim 2, **characterized in that** the piezoelectric resonator (1), at its point of contact with the rotor (4), and the rotor (4) itself have a cladding of a very hard material, particularly Al₂O₃.

6. A piezoelectric actuator as claimed in claim 1, **characterized in that** the longitudinally vibrating piezoelectric resonator (1) is a multi-layer resonator.

7. A piezoelectric actuator as claimed in claim 1, **characterized in that** the material of the guide elements (2a, 2b) has a smaller acoustic impedance than the material of the piezoelectric resonator (1).

8. An electrically powered shaver having at least one cutting member (21) driven by at least one piezoelectric actuator as claimed in claim 1.

9. An electrically powered shaver as claimed in claim 8, **characterized in that** the cutting member (21) has a rotor (2) which is rotationally drivable by an actuator (1) as claimed in any one of claims 2 to 7.

10. An electrically powered shaver as claimed in claim 9, **characterized in that** it has at least two cutting members (21) which are rotationally drivable by rotors (2) and the rotors (2) are rotatable with different speeds.

## Revendications

1. Actionneur (1) piézoélectrique pour l'entraînement d'une partie mobile (2) avec un résonateur (3) piézoélectrique allongé qui est prévu pour exécuter des oscillations longitudinales et sur lequel agissent des moyens élastiques (10),
**caractérisé en ce**
**que** le moyen élastique (10) s'appuie principalement dans la direction longitudinale sur le résonateur piézoélectrique (3) et est prévu pour exercer une force sur le résonateur (3) dans la direction de la partie mobile (2), la fréquence de résonance du moyen élastique (10) étant nettement inférieure à la fréquence de résonance du résonateur (3) piézoélectrique, et
**que** le résonateur piézoélectrique (3) est guidé perpendiculairement à sa direction longitudinale (11) par au moins un élément de guidage (4, 5).

2. Actionneur piézoélectrique selon la revendication 1,
**caractérisé en ce**
**que** le résonateur piézoélectrique (3) entraîne un rotor (2), le résonateur (3) piézoélectrique formant dans la direction d'oscillation un angle aigu (α) avec une ligne normale (12) qui s'étend perpendiculairement à un plan tangentiel (16) par un point de contact (7) du rotor (2) et du résonateur (3) et cet angle (α) assurant un degré d'efficacité maximal.

3. Actionneur piézoélectrique selon la revendication 2,
**caractérisé en ce**
**que** le résonateur (3) piézoélectrique présente au moins deux surfaces de guidage (14, 15) opposées et coopérant avec les éléments de guidage (4, 5), l'élément de guidage (4) formant sur la surface de guidage (14) du résonateur (3) piézoélectrique qui forme avec le plan tangentiel (16) sur le rotor (2) par le point de contact (7) du rotor (2) et du résonateur (3) un angle (β) supérieur à 90°, se trouve plus près du rotor (2) que tous les autres éléments de guidage (5) présents pour empêcher un soulèvement du résonateur (3) piézoélectrique du rotor (2).

4. Actionneur piézoélectrique selon la revendication 2,
**caractérisé en ce**
**que** l'angle (α) est inférieur à l'angle optimal pour le degré d'efficacité maximal.

5. Actionneur piézoélectrique selon la revendication 2,
**caractérisé en ce**
**que** le résonateur piézoélectrique (1) présente au point de contact avec le rotor (4) et le rotor (4) lui-même un revêtement à partir d'un matériau très dur, en particulier de l'Al₂O₃.

6. Actionneur piézoélectrique selon la revendication 1,
**caractérisé en ce**
**que** le résonateur (1) piézoélectrique à oscillations longitudinales est un résonateur à couches multiples.

7. Actionneur piézoélectrique selon la revendication 1,
**caractérisé en ce**
**que** le matériau des éléments de guidage (2a, 2b) présente une impédance acoustique inférieure au matériau du résonateur piézoélectrique (1).

8. Rasoir électrique avec au moins un élément de coupe (21) qui est entraîné par au moins un actionneur piézoélectrique selon la revendication 1.

9. Rasoir électrique selon la revendication 8,
**caractérisé en ce que** l'élément de coupe (21) présente un rotor (2) qui peut être entraîné à rotation par un actionneur (1) selon l'une des revendications 2 à 7.

10. Rasoir électrique selon la revendication 9,
**caractérisé en ce**
**que** celui-ci présente au moins deux éléments de coupe (21) à entraîner en rotation par des rotors (2) et que les rotors (2) tournent à des vitesses de rotation différentes.
